# EUROPEAN PATENT SPECIFICATION

(11) **EP 2 828 086 B1**
(45) Date of publication and mention of the grant of the patent: **11.09.2019**
(21) Application number: 12877853.7
(22) Date of filing: 31.05.2012
(51) Int. Cl.: B41J 2/175, B41J 2/14, B41J 2/045, H05K 3/10

(54) **PRINTHEADS WITH CONDUCTOR TRACES ACROSS SLOTS**
DRUCKKÖPFE MIT LEITERSPUREN DURCH SCHLITZE
TÊTES D'IMPRESSION AVEC PISTES CONDUCTRICES À TRAVERS DES FENTES

(43) Date of publication of application: 28.01.2015
(73) Proprietor: Hewlett-Packard Development Company, L.P., Spring TX 77389 (US)
(72) Inventor: RIVAS, Rio, Corvallis, Oregon 97330-4239 (US); BAKKER, Christopher, Corvallis, Oregon 97330-4239 (US); FRIESEN, Edward, Corvallis, Oregon 97330-4239 (US); PRZYBYLA, James R., Corvallis, Oregon 97330-4239 (US)
(74) Representative: ZBM Patents - Zea, Barlocci & Markvardsen
(86) International application number: PCT/US2012/040161
(87) International publication number: WO 2013/180715

(56) References cited:
- EP-A2- 1 078 753
- US-A- 5 953 032
- US-A- 6 019 907
- US-A1- 2002 008 732
- US-A1- 2006 044 347
- US-A1- 2011 019 210
- US-A1- 2011 205 303
- US-A1- 2012 019 597
- US-A1- 2012 019 597
- US-B2- 7 104 633
- US-B2- 7 946 690

## Description

### Background

Printing devices are widely used. These printing devices may utilize a printhead that includes a slot to deliver ink in the printing process. The printing devices may also include ink ejection elements enabling formation of text or images on a print medium. Such printing devices can provide multiple desirable characteristics at a reasonable price. US2012/0019597 discloses a printhead with cross-slot conductor routing. EP1078753 discloses a printhead having a thinfilm layer shelf. US2006/0044347 discloses a printhead including a heater. US2002/0008732 discloses a printhead comprising a heater. US6019907 discloses a monolithic printhead. US2011/0205303 discloses a fluid ejector structure.

### Brief Description of the Drawings

Figures 1A and 1B illustrate an example of a top-view schematic of a portion of a printhead circuit according to the present disclosure.
Figure 2 illustrates an example of a side-view schematic of a portion of printhead circuit formed according to the present disclosure.
Figure 3 illustrates an example of a fluid ejection device according to the present disclosure.

### Detailed Description

Printhead circuits, devices, and methods for forming the same, as described herein, can be used in a variety of printing devices. That is, the printing devices can utilize a printhead that can include a substrate, a slot, and/or fluid ejection elements to deliver fluid (e.g., ink) in the printing process. As printing technology improves, the ability to provide improved features and higher resolution becomes increasingly possible. Consumers may want, among other things, higher image resolution, realistic colors, and an increased printing rate (e.g., pages per minute).

As the level of resolution and the rate of printing increases, demand for power by the printhead can be increased. That is, increased resolution and/or operational speed of the printer can depend upon on an ability to reliably and/or efficiently power and/or control the fluid ejection elements of the printhead. Additionally, in an effort to improve reliability, a level of redundancy can be desirable in order to ensure functional operation of the printhead. However, the addition of redundancy (e.g., backup fluid ejection elements) can increase an amount of circuitry required to power, or potentially power, the fluid ejection elements of the printhead.

In order to provide space for the circuitry, a minimum substrate size need be maintained. However, maintaining a certain size can be less then desirable when one of the goals relating to the printhead may be to minimize the printhead (e.g., including the substrate) size in order to maximize the resolution, functionality, and number of potential printing devices the printhead can be used in conjunction with. Thus, it can be desirable to minimize the amount of the circuitry to enable a smaller and/or less costly printhead while maintaining a reliable and efficient printhead.

To realize such goals, a printhead circuit with conductor traces routed across a slot can be utilized. That is, a printhead circuit can include the slot and a number of conductor traces routed across the slot between circuitry on a first side surface and a second side surface of the slot. The conductor traces and/or the slot can be coupled with a number of fluid ejection elements to deliver fluid (e.g., ink) to a print media, as described herein. However, potential difficulties are that passing conductor traces across the slot can increase the cost, effort, and/or time of formation of the printhead circuit. Additionally, conductors traces passed across the slot may lead to the formation of bubbles that can reduce printing quality (e.g., resolution), rate, and/or cause unintended termination of printing.

Accordingly, forming conductor traces for electrical connectivity (e.g., electrical connections) across the slot in a manner conducive to avoiding formation of bubbles in the slot can improve reliability, print quality (e.g., resolution), and/or operational speed of printers. Further, the printhead circuits with conductor traces routed across the slot can be incorporated directly into a variety of printing devices because the printhead circuits can, as described herein, be small and/or readily fabricated, among other considerations.

In the detailed description of the present disclosure, reference is made to the accompanying drawings that form a part hereof and in that is shown, by way of illustration, examples of how the disclosure may be practiced. These examples are described in sufficient detail to enable those of ordinary skill in the art to practice the examples of this disclosure. It is to be understood that other examples may be utilized and that material variations and/or structural changes may be made without departing from the scope of the present disclosure. Further, where appropriate, as used herein, "for example" and "by way of example" should each be understood as an abbreviation for "by way of example and not by way of limitation".

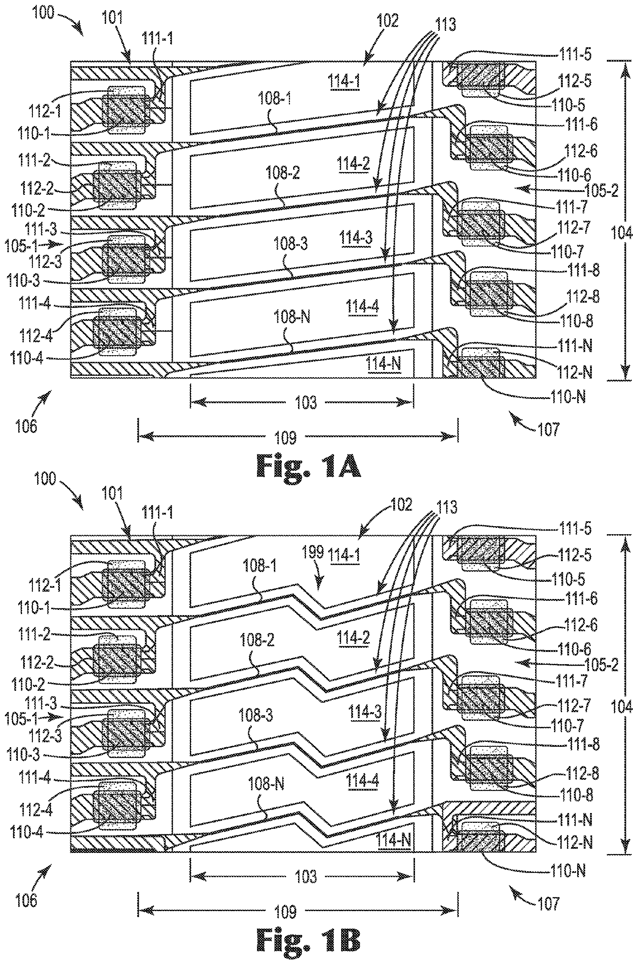

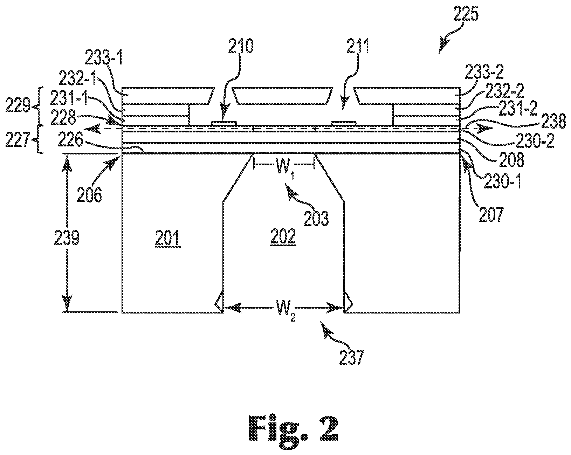

The figures herein follow a numbering convention in that the first digit or digits correspond to the drawing figure number and the remaining digits identify an element or component in the drawing. Similar elements or components between different figures may be identified by the use of similar digits. For example, 104 may reference element "104" in Figure 1, and a similar element may be referenced as "204" in Figure 2. Elements shown in the various figures herein can be added, exchanged, and/or eliminated so as to provide a number of additional examples of the present disclosure. In addition, the proportion and the relative scale of the elements provided in the figures are intended to illustrate the examples of the present disclosure and should not be taken in a limiting sense.

Unless otherwise indicated, all numbers expressing ranges and dimensions, and so forth, used in the specification and claims are to be understood as being modified in all instances by the terms "substantially" or "about". Accordingly, unless indicated to the contrary, the numerical parameters set forth in the following specification and attached claims are approximations that may vary depending upon the properties sought.

Figures 1A and 1B illustrate an example of a top-view schematic of a portion of a printhead circuit according to the present disclosure. As illustrated in Figure 1A, the example of the portion of the printhead circuit 100 can include a substrate 101 including a slot 102 having a first 103, a second 104, and a third dimension (e.g., 239 as illustrated in Figure 2) in the substrate 101. In various examples, the printhead circuit 100 can include circuitry 105-1,105-2 on a first side surface 106 and a second side surface 107 of the slot 102. In addition, in various examples, the printhead circuit 100 can include a number of conductor traces 108-1 through 108-N routed across the slot 102 along substantially a same geometrical plane (e.g., 238 as illustrated in Figure 2) as the circuitry 105-1,105-2 on the first side surface 106 and the second side surface 107 of the slot 102.

As described herein, the substrate 101 can be formed from a material selected from a group that includes gallium arsenide, ceramics, any suitable semiconducting material (e.g., a single crystalline silicon or a polycrystalline silicon), and/or combinations thereof. The material and/or a total thickness of the material can be chosen to achieve adequate structural support for the formation of the slot 102, a thinfilm bridge 113, and/or a fluidic layer (e.g., 229 as illustrated in Figure 2), as described herein. In some examples, the thickness of the substrate 101 can be in a range of from substantially 50 microns to substantially 2000 microns (e.g., 675 microns).

In various examples, the substrate 101(201 as illustrated in Figure 2) can include slots formed according to the methods described herein. Additionally, in some examples, the substrate 101 can include chambers 111-1 through 111-N coupled to the slot 102. In some examples, the chambers 111-1 through 111-N and/or the slot 102 can enable fluid (e.g., ink) to be received by a number of fluid ejection elements 110-1 through 110-N, as described herein.

The slot 102 can be defined, at least in part, by the first dimension 103 and/or the second dimension 104, as illustrated in Figures 1A and 1B. In some examples, the slot 102 can be substantially rectangular, as illustrated in Figures 1A and 1B. However, the present disclosure is not limited to such a configuration. That is, the shape of the slot 102 and/or angle of a number of walls (e.g., in the third dimension 239 as illustrated in Figure 2) of the slot 102, and a number, size, and configuration of the chambers 111-1 thorough 111-N, among other structural features, can be varied in a manner conducive to providing structural support for the printhead circuit 100 and/or reducing formation of bubbles in the slot 102, among other considerations.

Accordingly, the slot 102 can be scalable to form a slot of a particular length (e.g., the second dimension 104) and/or a particular width (e.g., the first dimension 103). In some examples, the first dimension 103 of the slot 102 can vary along a third dimension (e.g., 239 as illustrated in Figure 2) of the slot 102. That is, the first dimension (e.g., 203 as illustrated in Figure 2) at a first substrate location (e.g., at a first side surface 206 and/or a second side surface 207) can be substantially different than the first dimension (e.g., at 237 as illustrated in Figure 2) at a second substrate location (e.g., 235 a bottom surface of the substrate 201) of the slot 102. In some examples, the printhead circuit 100 can include a plurality of slots, as described herein.

As described herein, the number of fluid ejection elements 110-1 through 110-N can include heat-activated (e.g., thin film resistors) and/or pressure-activated (e.g., piezoelectric) elements. In some examples, the number of fluid ejection elements 110-1 thorough 110-N can be coupled to and/or included in a printhead circuit, as described herein.

The thinfilm bridge 113 can be formed from a material (e.g., a thinfilm) selected from a group that includes silicon oxide formed by thermal oxidation, silicon oxide formed by chemical vapor deposition precursor Tetraethyl Orthosilicate, silicate glass formed by chemical vapor deposition containing boron and phosphorus (BPSG), chrome, tantalum, aluminum, titanium, copper, tantalum nitride, silicon nitride, silicon carbide (SiC), and/or combinations thereof. In some examples, the thinfilm bridge 113 can connect the circuitry 105-1 on the first side surface 106 of the slot 102 to the circuitry 105-2 on the second side surface 107 of the slot 102, as described herein. That is, in some examples, the printhead circuit 100 includes a number of conductor traces, e.g., 108-1 thorough 108-N, in the thinfilm bridge 113 to connect the circuitry 105-1, 105-2 on the first side surface 106 and the second side of the slot 107. In the example shown, conductor traces 108-1 through 108-N in thinfilm bridges 113 provide a ground return for fluidic ejection elements 110-5 through 110-N.

Alternatively or in addition, in some examples, the printhead circuit 100 includes the number of conductor traces 108-1 through 108-N can multiple conductor traces in a thinfilm bridge 113. That is, a material can be provided with the thinfilm bridge 113 suitable to insulate a first conductor trace (e.g., 108-1) from a second conductor trace (not shown). In one example, the second conductor trace can be formed on a first surface of the first conductor trace (e.g., 108-1) with appropriate materials (e.g., dielectric) separating the same. In some examples, the printhead circuit 100 can include forming the first conductor trace the second conductor trace from different metals. The first conductor trace and the second conductor trace may perform different functions (e.g., transport different signal types), as described herein.

As illustrated in Figures 1A and 1B, in some examples, the thinfilm bridge 113 can include a number of openings 114-1 through 114-N (e.g., formed using the methods described herein). In some examples, a combined area of the number of openings 114-1 through 114-N can be in a range of from substantially 10% to substantially 80% of an overall area (e.g., as defined by the first dimension 103 and the second dimension 104 of the slot 102) above the slot 102, as illustrated in Figures 1A and 1B.

The shape of the number of openings 114-1 through 114-N can include substantially circular, elliptical, rectangular, triangular, rhomboidal, and/or trapezoidal, among others, depending upon a particular mask layer. As illustrated in Figures 1A and 1B, the shape and size of the number of openings 114-1 through 114-N can be substantially the same shape and size. However, the disclosure is not limited to such a configuration. That is, the shape, size, number, and configuration of the number of openings 114-1 through 114-N can be varied in a manner conducive to achieve desired properties. Examples of the desired properties can include promoting fluid flow in the printhead circuit 100, enabling formation of the number of conductor traces 108-1 through 108-N to pass a desired signal, reducing heat accumulation in the printhead circuit 100, and/or providing structural support for the printhead circuit 100, among other considerations.

As described herein, the number of conductor traces 108-1 through 108-N can be formed of a material that includes copper, aluminum, titanium, chrome, nickel, steel, and/or combinations thereof, among others. Accordingly, the material and/or thickness of the material can be chosen to enable transmission of the desired signal and/or contribute to mechanical flexibility of the number of conductor traces 108-1 through 108-N. In some examples, the number of conductor traces 108-1 though 108-N each can have a width in a range of from substantially 0.5 micrometers (µm) to substantially 25 µm and a thickness in the range of 500 angstroms to 20,000 angstroms.

As illustrated in Figure 1A and 1B, in some examples, the printhead circuit 100 can include a path (e.g., that of 108-1) of at least one of the number of conductor traces 108-1 though 108-N routed across the slot 102 that has a first dimension 109 greater than the first dimension 103 of the slot 102. In some examples, the number of conductor traces 108-1 through 108-N can be routed to substantially an edge of the substrate 101. Additionally, in some examples, one or more of the number of conductor traces 108-1 through 108-N can continue beyond a first and/or a second dimensions of the substrate 101 (e.g., 108-1 as illustrated in Figures 1A and 1B).

Alternatively or in addition, in some examples, the path of at least one of the number of conductor traces 108-1 though 108-N can include a direction change 199 in the path passing across the slot 102, as illustrated in Figure 1B. However the disclosure is not limited to such a configuration. That is, the number of, and/or degree of the direction change 199 can be varied in a manner conducive to a design rule and/or a consideration, for example, transmission of electricity (e.g., the desired signal), as described herein, and/or providing a desired amount of mechanical flexibility in the number of conductor traces 108-1 though 108-N.

In some examples, the number of conductor traces 108-1 through 108-N can provide electrical connections from the first side surface 106 of the slot 102 to the number of fluid ejection elements 110-1 through 110-N on the second side surface 107 of the slot 102. In some examples, at least one of the number of conductor traces 108-1 through 108-N can conduct a control signal from the first side surface 106 of the slot 102 to a component responsive (e.g., 110) to the control signal on the second side surface 107 of the slot 102. Control signals can include status verification and/or on or off signals, among others. In some examples, the number of conductor traces 108-1 through 108-N can serve as a common ground for two or more of the number of fluid ejection elements 110-1 through 110-N, as illustrated in Figures 1A and 1B.

Figure 2 illustrates an example of a side-view schematic of a portion of printhead circuit formed according to the present disclosure. As illustrated in Figure 2, a method of forming a printhead circuit 225 with a number of conductor traces 208 (108-1 through 108-N as illustrated in Figures 1A and 1B) across a slot 202 can include forming a thinfilm bridge 227 on a first surface 226 of a substrate 201. In various examples, forming the thinfilm bridge 227 can include depositing a number of thinfilm layers 230-1, 230-2, positioning the number of conductor traces (e.g., 108-1 through 108-N as illustrated in Figure 1A and 1B) in a single plane (e.g., 238 as illustrated in Figure 2) across the slot 202, with the number of conductor traces (e.g., 108-1 through 108-N) having a first dimension (e.g., 109 as illustrated in Figures 1A and 1B) greater than a predetermined first dimension 203 of the slot 202, patterning the number of thinfilm layers 230-1, 230-2, forming a fluidic layer 229 on a first surface 228 of the thinfilm bridge 227, and forming the slot 202 of the predetermined first dimension 203 in the substrate 201, as described herein. Positioning the number of conductor traces (e.g., 108-1 through 108-N as illustrated in Figures 1A and 1B) along substantially the same geometric plane (e.g., 238) as circuitry (e.g., 105 as illustrated in Figures 1A and 1B) on a first side surface 206 and a second side surface 207 of the slot 202 can enable easier formation of the printhead circuit (e.g., 225)(e.g., reduction in the time, energy, or materials for forming), efficient (e.g., reducing energy loss during transmission) and/or reliable of transmission of electrical signals (e.g., control signals), and/or promoting a desired characteristic (e.g., flexibility) and/or configuration of the number of conductor traces 108-1 though 108-N, among other advantages.

Additionally, in some examples, the method for forming a printhead circuit 225 can include the number of conductor traces (e.g., 108-1 through 108-N as illustrated in Figures 1A and 1B) to conduct electricity and/or control signals from the first side surface (e.g., 106) of the slot 202 to a component (not shown) responsive to the control signal on the second side surface (e.g., 107) of the slot 202. As described herein, in some examples, forming a thinfilm bridge 227 on the first surface 226 of a substrate 201 can include forming the thinfilm bridge 227 by depositing a number of thinfilm layers 230-1, 230-2 and positioning the number of conductor traces (e.g., 208) in a single plane 238 across the slot 202, such that the number of conductor traces (e.g., 208) can have a first dimension (e.g., 109 as illustrated in Figures 1A and 1B) greater than a predetermined first dimension 203 of the slot 202. In addition, in some examples, forming the thinfilm bridge 227 can include patterning (e.g., forming a number of openings in) the number of thinfilm layers 230-1, 230-2, as described herein.

As illustrated in Figure 2, in some examples, forming the fluidic layer 229 can include depositing and/or patterning a primer layer 231-1, 231-2 on a first surface 228 of the thinfilm bridge 227. In some examples, forming the fluidic layer 229 can include depositing and patterning a chamber layer 232-1, 232-2 on a first surface of the primer layer 231-1, 231-2 to form a number of chambers (e.g., 211). Additionally, in some examples, the method can include depositing a wax (not shown) into the chambers (e.g., 211). In some examples, the method can include depositing and/or patterning a nozzle layer 233-1, 233-2 on a first surface of the chamber layer 232-1, 232-2 and/or removing the wax from the number of chambers (e.g., 211). That is, the fluidic layer 229 can include the nozzle layer (e.g., 233), chamber layer (e.g., 232), and/or the primer layer (e.g., 231).

Accordingly, in some examples, a photo imaginable epoxy (e.g., SU-8) can form a number of chambers (e.g., 211). In addition, in some examples, the number of chambers (e.g., 211) can include a number of fluid ejection elements (e.g., 210). That is, in some examples the number of fluid ejection elements (e.g., 210) can be coupled to the slot 202, for example, by one of the number of chambers (e.g., 211). Additionally, in some examples, the slot 202 and the number of fluid ejection elements (e.g., 210) can be integral.

As described herein, patterning can include forming the desired thickness, openings in, and/or shape of the thinfilm bridge 227, nozzle layer 233-1, 233-2, chamber layer 232-1, 232-2, and/or the primer layer 231-1, 231-2 using of the methods (e.g., a laser and/or a wet process etch) described herein. Alternatively or in addition, in some examples the method can include curing the primer layer 231-1, 231-2, the chamber layer 232-1, 232-2, and/or the nozzle layer 233-1, 233-2. For example, curing can include heat, ultraviolet light, and/or pressure applied to the primer layer (e.g., 231), the chamber layer (e.g., 232), and/or the nozzle layer (e.g., 233).

As illustrated in Figure 2, in some examples, forming the slot 202 can include forming the slot 202 with a laser and/or etching processes (e.g., the wet process etch). However, the present disclosure is not limited to such means. That is, the slot 202 can be formed utilizing any of the techniques described herein. For example, the slot 202 can be formed using techniques such as sand drilling, mechanical drilling, etching, laser, an air aided laser, a water aided laser, and/or combination thereof. In some examples, forming the slot 202 can include forming the slot with a laser, as described herein. In addition, in some examples, forming the number of openings (e.g., 114-1 through 114-N as illustrated in Figures 1A and 1B) can include forming the number of openings with a laser, as described herein.

As described herein, a laser can be either a pulse or continuous laser. Pulsed operation of a laser (e.g., a pulse laser) refers to any laser not classified as continuous wave (e.g., a continuous laser), so that the photons can be applied in pulses of a defined duration at a defined repetition rate. Alternatively, continuous lasers can utilize a beam whose output can be constant over time. In some examples, the laser can control the shape, orientation, surface roughness (e.g., by removing sharp edges and/or rough material from the top and/or bottom surface of the substrate and/or from the walls of the slot 202, and/or the number of openings (e.g., 114-1 through 114-N as illustrated in Figures 1A and 1B) in a manner conducive to reducing crack initiation and/or bubble formation sites. Operating in pulsed and/or continuous mode can satisfy applications as described herein.

Alternatively or in addition, in some examples, the lasers can be multi-mode (e.g., having multiple outputs based on a variety of selectable output parameters). As used herein, utilizing a multi-mode laser can account for various factors (e.g., the size and/or shape of the slot 202, the particular material and/or configuration of the substrate 201 among other considerations). Based on such considerations, the laser can be adjusted to emit a wavelength of a particular frequency and/or diameter.

In various examples, the laser can have a laser beam with a diameter in a range of from substantially 5 microns to substantially 100 microns. The laser can apply the laser beam to the substrate 201 one or a plurality of times. That is, for example, the laser beam can make multiple passes over a first portion of the substrate 201 and/or a single pass over a second portion of the substrate 201. A speed the laser beam can move over the substrate 201 and/or a focus of the beam also can be varied to achieve different results depending on the application. In some examples, the laser can have a debris extraction system (e.g., a water-aided laser) that can remove debris resulting from laser machining.

As described herein, etching (e.g., wet process etch) is a process for removal of one or a plurality of portions (e.g., unprotected portions) of a surface using a suitable etchant (e.g., tetramethylammonium hydroxide (TMAH), among others). In some examples, the top surface 226 and/or bottom surface 235 of the substrate 201 can be exposed to an etchant sufficient to remove at least a portion of the substrate 201 material(s) to form at least a portion of the slot 202. Alternatively or in addition, in some examples, etching can include patterning the thinfilm bridge 227, as described herein.

In some examples, etching can control the shape, orientation, surface roughness, and/or size of the slot 202, the number of chambers (e.g., 211) and/or from the number of openings (e.g., 114-1 through 114-N as illustrated in Figures 1A and 1B). In addition, in some examples, the etchant can remove sharp edges and/or rough material from the top surface and/or bottom surface 235 of the substrate and/or the number of openings (e.g., 114-1 through 114-N as illustrated in Figures 1A and 1B). This can be conducive to reducing crack initiation and/or bubble formation sites.

In some examples, the method of forming the printhead circuit 225 can include depositing a protective layer (not shown) on a number of surfaces of the thinfilm bridge 227. That is, a layer of a material (e.g., silicon carbide) can be formed on the number of surfaces of the thinfilm bridge 227 to provide the desired properties (e.g., corrosion protection for fluid). In some examples, the protective layer and the thinfilm bridge 227 can be integral. Alternatively or in addition, in some examples, the printhead circuit can include forming a material (not shown), for example a polymer (e.g., a photo imagable polymer), on a potion of a bottom surface 235 of the substrate 202. This layer (e.g., mask) can enable masking (e.g., inhibiting etching on) a portion of the substrate 202 during etching, as described herein.

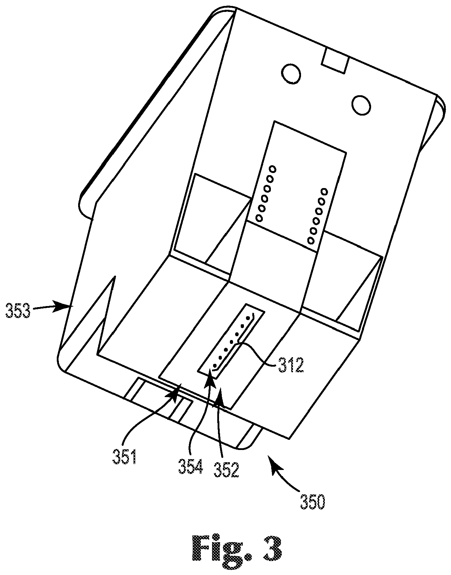

Figure 3 illustrates an example of a fluid ejection device according to the present disclosure. As illustrated in Figure 3, in various examples, a fluid ejection device 350 can include a housing 353 including a reservoir (not shown) for holding fluid. In various examples, the fluid ejection 350 device can include a printhead circuit 354 affixed to the housing 353. Additionally, in various examples, the printhead circuit 350 can include a number of fluid ejection elements (e.g., 110 as illustrated in Figure 1A and 1B) including a number of nozzles 312 operatively connected to the reservoir for ejecting fluid (e.g., ink) from the printhead circuit 354.

In various examples, the printhead circuit 354 can include a substrate (e.g., 101 as illustrated in Figure 1A and 1B) including a slot (e.g., 102) having a first (e.g., 103), a second (e.g., 104), and a third dimension (e.g., 239 as illustrated in Figure 2) in the substrate (e.g., 101), circuitry (e.g., 105) on a first side surface (e.g., 106) and a second side surface (e.g., 107) of the slot (e.g., 102); and/or a number of conductor traces (e.g., 108) routed across (e.g., a path of at least one of the number of conductor traces (e.g., 108) the slot (e.g., 102) having a first dimension (e.g., 109) greater than the first dimension (e.g., 103) of the slot (e.g., 102) the slot (e.g., 102) along substantially a same geometrical plane (e.g., 238) as the circuitry (e.g., 105) on the first side surface (e.g. 106) and the second side surface (e.g., 107) of the slot (e.g., 102). In some examples, the fluid ejection device 350 can include the number of conductor traces (e.g., 108) having a direction change (e.g., 199 as illustrated in Figure 1B) in a path passing across the slot (e.g., 102).

As illustrated in Figure 3, in some examples, the printhead circuit 354 and the flex circuit 352 can be bonded by the interconnect circuit 351 that can be attached (e.g., by adhesive) to the housing 353 of the fluid ejection device 350. Additionally, in some embodiments, the housing 353 can include an fluid (e.g., ink) reservoir (e.g., for an inkjet cartridge not shown. That is, the fluid ejection device 350 can include the flex circuit 352 and/or the printhead circuit 354 configured to control the number of fluid ejection elements (e.g., 110 as illustrated in Figures 1A and 1B) including a number of nozzles 312 that can be attached to the housing 353, the printhead circuit 354, and/or the flex circuit 352 with leads (e.g., formed of copper not shown), and a eutectic bond between each of the leads and electrical connection points (e.g., formed of gold not shown) on the printhead circuit 354 to form the interconnect circuit 351. In some circumstances, the completed interconnect circuit 351 can be attached to another component as an electronic control component in an electronic device.

The printhead circuit 354 can be configured to electronically control operation and timing of the number of fluid ejection elements (e.g., 110 as illustrated in Figures 1A and 1B)(e.g., of continuous, thermal, and piezoelectric inkjet printers, among others) that eject fluid (e.g., in the form of ink droplets) through the number of nozzles 312 of the fluid ejection device 350. The fluid ejection device 350 and the number of fluid ejection elements (e.g., 110 as illustrated in Figures 1A and 1B) including the number of nozzles 312 illustrated in Figure 3 are shown by way of example and not by way of limitation.

In some examples, the fluid ejecting device 350 can be included in an inkjet cartridge. That is, the cartridges of some printing devices (e.g., inkjet printers) can each include a printhead circuit. Inkjet cartridges have various configurations, such as having color and black inks in a single cartridge, separate cartridges for black and colored inks, or a separate cartridge for black and each of the ink colors, among other configuration possibilities. In some applications of the present disclosure, an inkjet cartridge can have a housing 353 including a reservoir therein for holding ink and a printhead circuit affixed to the housing 353, the printhead circuit 354 having ink ejection elements (e.g., 110 as illustrated in Figures 1A and 1B) operatively connected to the reservoir for ejecting fluid (e.g., ink) drops via the number of nozzles 312 from the printhead circuit 354. The term "printing device" refers to any type of printing device and/or image forming device that can employ printhead circuit(s) to achieve at least a portion of its functionality. Examples of such printing devices can include, but are not limited to, printers, facsimile machines, and/or photocopiers.

Accordingly, in some examples the printhead circuit 354 can include the number of fluid ejection devices (e.g., 110) that can include the number of nozzles 312. In some examples the printhead circuit 354 can include a nozzle plate (not shown) including the number of nozzles 312. The nozzle plate can be made from an electroformed metal, a photo imageable epoxy, and/or a polyimide, among others. The number of nozzles 312 can be formed by any suitable method (e.g., by laser ablation). In some examples, the nozzle plate can be integral with the primer (e.g., 231 as illustrated in Figure 2), chamber (e.g., 232), and/or nozzle layers (e.g., 233).

The number of nozzles 312 can by arranged in columns or arrays along the slot (e.g., 102 as illustrated in Figures 1A and 1B) such that properly sequenced ejection of fluid can cause characters, symbols, and/or other graphics or images to be printed on point media (e.g., as the printhead and print media are moved relative to each other). The print media can be any type of suitable sheet or roll material, such as paper, card stock, transparencies, Mylar, polyester, plywood, foam board, fabric, and/or canvas, among others.

Additionally, in some examples, at least one of the number of conductor traces (e.g. 108-1 as illustrate in Figures 1A and 1B) can be coupled to a drop sensing component (not shown) associated with the number of nozzles (e.g., 112). For example, a conductor trace (e.g., 108) can encounter a nozzle (e.g., 112) such that the nozzle can bisect the conductor trace. That is, one or more of the number of conductor traces (e.g., 108) can be divided into two sections with a space between the two sections with each section located substantially on opposing sides of the number of nozzle(s) (e.g., 112) to enable fluid (e.g., ink) drop sensing by the drop sensing component.

As described herein, circuitry (e.g., 105) can include integrated circuitry (e.g., monolithic and/or hybrid integrated circuits). In some examples, the circuitry can be formed by patterning a diffusion of a number of trace elements into and/or on a surface of a substrate (e.g., 101). Additional, in some examples, the substrate (e.g., 101) can include one or more semiconducting materials (e.g., silicon). In some examples, the circuitry (e.g., 105) can be coupled to the number of fluid ejection elements (e.g., 110) and/or the drop sensing component (not shown), among others.

The printing device can include one or more processors. The processors can control various printer operations, such as media handling and/or carriage movement for linear positioning of the fluid ejecting elements (e.g., 110) over a print media (e.g., paper, transparency, etc.). In some examples, the processors can communicate with other electronic and/or computing devices. The printing device can, in some examples, have an electrically erasable programmable read-only memory (EPROM), read-only memory (ROM), and/or a random access memory (RAM). The memory components (e.g., EPROM, ROM, and/or RAM), can store various information and/or data such as configuration information, fonts, templates, data being printed, and/or menu structure information. In some examples, a printing device can also include a flash memory device in place of or in addition to the memory components (e.g., EPROM). In some examples, a system bus can connect the various components (e.g., EPROM) within the printing device.

Alternatively or in addition, the printing device can, in some examples, have a firmware component that can be implemented as a permanent memory module stored in memory (e.g., ROM). The firmware can be programmed and/or tested like software. In some examples, the firmware can be distributed along with the printing device to enable implementing and/or coordinating operations of the hardware within printing device and/or contain programming constructs used to perform such operations.

The small size of the printhead circuit makes substrates including multiple slots practical. As such, in some examples, the printhead circuit can include the plurality of slots in the substrate. In some examples, the number of conductor traces can pass over two or more slots. In some examples, the plurality of the slots can be coupled to a single fluid supply, as described herein. Alternatively, the plurality of slots can divide the fluid supply so that each of the plurality of slots receives a separate fluid supply.

The present disclosure includes apparatuses and methods for implementing a printhead circuit. Printhead circuits can be used for the applications described in the present disclosure, although the printhead circuits are not limited to such applications. It is to be understood that the above description has been made in an illustrative fashion and not a restrictive one. Although specific examples for apparatuses and methods have been illustrated and described herein, other equivalent component arrangements and/or structures conducive to structural support of the printhead circuits and/or efficient printing can be substituted for the specific examples shown herein.

## Claims

1. A printhead circuit (100, 225, 354) comprising:
a substrate (101, 201) including a slot (102, 202) having a first (103), a second (104), and a third (239) dimension in the substrate (101, 201);
circuitry (105) on a first side (106, 206) and a second side (107, 207) of the slot, (102, 202) the circuitry (105) comprising at least fluid ejection elements (110, 210); and
a number of conductor traces (108, 208) in a thinfilm bridge (113, 227) formed on a first surface (226) of the substrate (101, 201) and routed across the slot (102, 202) along substantially a same geometrical plane (238) as the circuitry (105) on the first side (106, 206)) and the second side (107, 207) of the slot (102, 202), whereby the thinfilm bridge (113, 227) connects the circuitry (105) on the first side (106, 206) and the second side (107, 207) of the slot (102, 202).

2. The printhead circuit of claim 1, comprising a path of at least one of the number of conductor traces (108, 208) routed across the slot (102, 202) having a first dimension (109) greater than the first dimension (103) of the slot (102, 202).

3. The printhead circuit of claim 2, wherein the path of at least one of the number of conductor traces (108, 208) comprises a direction change (199) in the path passing across the slot (102, 202).

4. The printhead circuit of claim 1, wherein the number of conductor traces (108, 208) each have a width in a range of from substantially 0.5 micrometers (µm) to substantially 25 µm.

5. The printhead circuit of claim 1, wherein the number of conductor traces (108, 208) comprises a first conductor trace and a second conductor trace, wherein a thinfilm is formed on a first surface of the first conductor trace and the second conductor trace is formed on a first surface of the thinfilm, whereby the thinfilm forms the thinfilm bridge.

6. The printhead circuit of claim 5, wherein the first conductor trace and the second conductor trace are formed from different metals.

7. The printhead circuit of claim 1, wherein the thinfilm bridge (113, 227) includes a number of openings (114) comprising a combined area of the number of openings (114) in a range of from substantially 10% to substantially 80% of an overall area above the slot (102, 202).

8. A fluid ejection device (350), comprising:
a housing (353) including a reservoir for holding fluid;
a printhead circuit (100, 225, 354) according to any of claims 1 to 7, affixed to the housing (353); and whereby the number of fluid ejection elements (110, 210) is including a number of nozzles (112, 312) operatively connected to the reservoir for ejecting fluid from the printhead circuit (100, 225, 354).

9. The device of claim 8, wherein the number of conductor traces (108, 208) have a direction change (199) in a path passing across the slot (102, 202).

10. A method of forming a printhead circuit (100, 225, 354) with a number of conductor traces (108, 208) across a slot (102, 202), comprising:
forming a thinfilm bridge (113, 227) on a first surface (226) of a substrate (101, 201), wherein forming the thinfilm bridge (113, 227) comprises:
depositing a number of thinfilm layers (230);
positioning the number of conductor traces (108, 208) in the number of thinfilm layers (230) along substantially a same geometrical plane (238) as circuitry (105) on a first side (106, 206) and a second side (107, 207) of the slot (102, 202), the circuitry (105) comprising at least fluid ejection elements (110, 210), wherein the number of conductor traces (108, 208) have a first dimension (109) greater than a predetermined first dimension (103) of the slot (102, 202);
patterning the number of thinfilm layers (230);
forming a fluidic layer (229) on a first surface (228) of the thinfilm bridge (113, 227); and
forming the slot (102, 202) of the predetermined first dimension (103) in the substrate (101, 201).

11. The method of claim 10, wherein at least one of the number of conductor traces (108, 208) provides electrical connections from the first side (106, 206) of the slot (102, 202) to a number of fluid ejection devices on the second side (107, 207) of the slot (102, 202).

12. The method of claim 10, wherein at least one of the number of conductor traces (108, 208) conducts control signals from the first side (106, 206) of the slot (102, 202) to a component responsive to the control signal on the second side (107, 207) of the slot (102, 202).

13. The method of claim 10, wherein forming the slot (102, 202) comprises forming the slot (102, 202) using a laser and wet process etch.

14. The method of claim 10, wherein the method includes depositing a protective layer on a number of surfaces of the thinfilm layers (230).

## Patentansprüche

1. Druckkopfschaltung (100, 225, 354), die Folgendes umfasst:
ein Substrat (101, 201) einschließlich eines Schlitzes (102, 202) mit einer ersten (103), einer zweiten (104) und einer dritten (239) Abmessung in dem Substrat (101, 201);
eine Schaltungsanordnung (105) auf einer ersten Seite (106, 206) und einer zweiten Seite (107, 207) des Schlitzes (102, 202), wobei die Schaltungsanordnung (105) wenigstens Fluidausstoßelemente (110, 210) umfasst; und
eine Anzahl von Leiterbahnen (108, 208) in einer Dünnfilmbrücke (113, 227), die auf einer ersten Oberfläche (226) des Substrats (101, 201) ausgebildet sind und über den Schlitz (102, 202) entlang einer im Wesentlichen gleichen geometrischen Ebene (238) wie die Schaltungsanordnung (105) auf der ersten Seite (106, 206) und der zweiten Seite (107, 207) des Schlitzes (102, 202) geleitet sind, wodurch die Dünnfilmbrücke (113, 227) die Schaltungsanordnung (105) auf der ersten Seite (106, 206) und der zweiten Seite (107, 207) des Schlitzes (102, 202) verbindet.

2. Druckkopfschaltung nach Anspruch 1, die einen Pfad von wenigstens einer der Anzahl von Leiterbahnen (108, 208), die über den Schlitz (102, 202) geleitet sind, umfasst, mit einer ersten Abmessung (109), die größer als die erste Abmessung (103) des Schlitzes (102, 202) ist.

3. Druckkopfschaltung nach Anspruch 2, wobei der Pfad von wenigstens einer der Anzahl von Leiterbahnen (108, 208) eine Richtungsänderung (199) in dem Pfad, der über den Schlitz (102, 202) verläuft, umfasst.

4. Druckkopfschaltung nach Anspruch 1, wobei die Anzahl von Leiterbahnen (108, 208) jeweils eine Breite in einem Bereich von im Wesentlichen 0,5 Mikrometer (µm) bis im Wesentlichen 25 µm aufweist.

5. Druckkopfschaltung nach Anspruch 1, wobei die Anzahl von Leiterbahnen (108, 208) eine erste Leiterbahn und eine zweite Leiterbahn umfasst, wobei ein Dünnfilm auf einer ersten Oberfläche der ersten Leiterbahn ausgebildet ist und die zweite Leiterbahn auf einer ersten Oberfläche des Dünnfilms ausgebildet ist, wodurch der Dünnfilm die Dünnfilmbrücke ausbildet.

6. Druckkopfschaltung nach Anspruch 5, wobei die erste Leiterbahn und die zweite Leiterbahn aus unterschiedlichen Metallen ausgebildet sind.

7. Druckkopfschaltung nach Anspruch 1, wobei die Dünnfilmbrücke (113, 227) eine Anzahl von Öffnungen (114) einschließt, die einen kombinierten Bereich der Anzahl von Öffnungen (114) in einem Bereich von im Wesentlichen 10 % bis im Wesentlichen 80 % eines Gesamtbereichs über dem Schlitz (102, 202) umfassen.

8. Fluidausstoßvorrichtung (350), die Folgendes umfasst:
ein Gehäuse (353), das einen Behälter zum Enthalten von Fluid einschließt;
eine Druckkopfschaltung (100, 225, 354) nach einem der Ansprüche 1 bis 7, die an dem Gehäuse (353) befestigt ist; und wodurch die Anzahl von Fluidausstoßelementen (110, 210) eine Anzahl von Düsen (112, 312) einschließt, die mit dem Behälter wirkverbunden sind, um Fluid aus der Druckkopfschaltung (100, 225, 354) auszustoßen.

9. Vorrichtung nach Anspruch 8, wobei die Anzahl von Leiterbahnen (108, 208) eine Richtungsänderung (199) in einem Pfad aufweisen, der über den Schlitz (102, 202) verläuft.

10. Verfahren zum Ausbilden einer Druckkopfschaltung (100, 225, 354) mit einer Anzahl von Leiterbahnen (108, 208) über einen Schlitz (102, 202), das Folgendes umfasst:
Ausbilden einer Dünnfilmbrücke (113, 227) auf einer ersten Oberfläche (226) eines Substrats (101, 201), wobei das Ausbilden der Dünnfilmbrücke (113, 227) Folgendes umfasst:
Abscheiden einer Anzahl von Dünnfilmschichten (230);
Positionieren der Anzahl von Leiterbahnen (108, 208) in der Anzahl von Dünnfilmschichten (230) entlang einer im Wesentlichen gleichen geometrischen Ebene (238) wie eine Schaltungsanordnung (105) auf einer ersten Seite (106, 206) und einer zweiten Seite (107, 207) des Schlitzes (102, 202), wobei die Schaltungsanordnung (105) wenigstens Fluidausstoßelemente (110, 210) umfasst, wobei die Anzahl von Leiterbahnen (108, 208) eine erste Abmessung (109) aufweist, die größer als eine vorbestimmte erste Abmessung (103) des Schlitzes (102, 202) ist;
Strukturieren der Anzahl von Dünnfilmschichten (230);
Ausbilden einer fluidischen Schicht (229) auf einer ersten Oberfläche (228) der Dünnfilmbrücke (113, 227) und
Ausbilden des Schlitzes (102, 202) der vorbestimmten ersten Abmessung (103) in dem Substrat (101, 201).

11. Verfahren nach Anspruch 10, wobei wenigstens eine der Anzahl von Leiterbahnen (108, 208) elektrische Verbindungen von der ersten Seite (106, 206) des Schlitzes (102, 202) einer Anzahl von Fluidausstoßvorrichtungen auf der zweiten Seite (107, 207) des Schlitzes (102, 202) bereitstellt.

12. Verfahren nach Anspruch 10, wobei wenigstens eine der Anzahl von Leiterbahnen (108, 208) Steuersignale von der ersten Seite (106, 206) des Schlitzes (102, 202) zu einer Komponente, die auf das Steuersignal auf der zweiten Seite (107, 207) des Schlitzes (102, 202) anspricht, leitet.

13. Verfahren nach Anspruch 10, wobei das Ausbilden des Schlitzes (102, 202) ein Ausbilden des Schlitzes (102, 202) unter Verwendung einer Laser- und Nassverfahrensätzung umfasst.

14. Verfahren nach Anspruch 10, wobei das Verfahren ein Abscheiden einer Schutzschicht auf einer Anzahl von Oberflächen der Dünnfilmschichten (230) einschließt.

## Revendications

1. Circuit de tête d'impression (100, 225, 354) comprenant :
un substrat (101, 201) comprenant une fente (102, 202) ayant une première (103), une deuxième (104), et une troisième (239) dimension dans le substrat (101, 201);
des circuits (105) sur un premier côté (106, 206) et un second côté (107, 207) de la fente, (102, 202) les circuits (105) comprenant au moins des éléments d'éjection de fluide (110, 210) ; et
un certain nombre de pistes conductrices (108, 208) dans un pont de couches minces (113, 227) formé sur une première surface (226) du substrat (101, 201) et acheminé à travers la fente (102, 202) le long d'un plan géométrique sensiblement identique (238) à celui des circuits (105) sur le premier côté (106, 206) et le second côté (107, 207) de la fente (102, 202), le pont de couches minces (113, 227) connectant les circuits (105) sur le premier côté (106, 206) et le second côté (107, 207) de la fente (102, 202).

2. Circuit de tête d'impression selon la revendication 1, comprenant un trajet d'au moins une piste conductrice parmi le nombre de pistes conductrices (108, 208) acheminées à travers la fente (102, 202) ayant une première dimension (109) supérieure à la première dimension (103) de la fente (102, 202).

3. Circuit de tête d'impression selon la revendication 2, dans lequel le trajet d'au moins une piste conductrice parmi le nombre de pistes conductrices (108, 208) comprend un changement de direction (199) dans le trajet traversant la fente (102, 202).

4. Circuit de tête d'impression selon la revendication 1, dans lequel le nombre de pistes conductrices (108, 208) ont chacune une largeur dans une plage allant de sensiblement 0,5 micromètres (µm) à sensiblement 25 µm.

5. Circuit de tête d'impression selon la revendication 1, dans lequel le nombre de pistes conductrices (108, 208) comprend une première piste conductrice et une seconde piste conductrice, dans lequel une couche mince est formée sur une première surface de la première piste conductrice et la seconde piste conductrice est formée sur une première surface de la couche mince, la couche mince formant le pont de couches minces.

6. Circuit de tête d'impression selon la revendication 5, dans lequel la première piste conductrice et la seconde piste conductrice sont formées à partir de métaux différents.

7. Circuit de tête d'impression selon la revendication 1, dans lequel le pont de couches minces (113, 227) comprend un certain nombre d'ouvertures (114) comprenant une zone combinée du nombre d'ouvertures (114) dans une plage allant de sensiblement 10 % à sensiblement 80 % d'une zone totale au-dessus de la fente (102, 202).

8. Dispositif d'éjection de fluide (350) comprenant :
un boîtier (353) comprenant un réservoir pour contenir le fluide ;
un circuit de tête d'impression (100, 225, 354) selon l'une quelconque des revendications 1 à 7, apposé au boîtier (353) ; et le nombre d'éléments d'éjection de fluide (110, 210) comprenant un certain nombre de buses (112, 312) reliées de manière fonctionnelle au réservoir pour éjecter le fluide du circuit de tête d'impression (100, 225, 354).

9. Dispositif selon la revendication 8, dans lequel le nombre de pistes conductrices (108, 208) ont un changement de direction (199) dans un trajet traversant la fente (102, 202).

10. Procédé de formation d'un circuit de tête d'impression (100, 225, 354) au moyen d'un certain nombre de pistes conductrices (108, 208) à travers une fente (102, 202), consistant à :
former un pont de couches minces (113, 227) sur une première surface (226) d'un substrat (101, 201), dans lequel la formation du pont de couches minces (113, 227) consiste à :
déposer un certain nombre de couches minces (230) ;
positionner le nombre de pistes conductrices (108, 208) dans le nombre de couches minces (230) le long d'un plan géométrique (238) sensiblement identique à celui des circuits (105) sur un premier côté (106, 206) et un second côté (107, 207) de la fente (102, 202), les circuits (105) comprenant au moins des éléments d'éjection de fluide (110, 210), dans lequel le nombre de pistes conductrices (108, 208) ont une première dimension (109) supérieure à une première dimension (103) prédéfinie de la fente (102, 202) ;
former un motif dans le nombre de couches minces (230) ;
former une couche fluidique (229) sur une première surface (228) du pont de couches minces (113, 227) ; et
former la fente (102, 202) de la première dimension prédéfinie (103) dans le substrat (101, 201).

11. Procédé selon la revendication 10, dans lequel au moins une piste conductrice parmi le nombre de pistes conductrices (108, 208) fournit des connexions électriques du premier côté (106, 206) de la fente (102, 202) à un certain nombre de dispositifs d'éjection de fluide sur le second côté (107, 207) de la fente (102, 202).

12. Procédé selon la revendication 10, dans lequel au moins une piste conductrice parmi le nombre de pistes conductrices (108, 208) conduit des signaux de commande du premier côté (106, 206) de la fente (102, 202) à une composante sensible au signal de commande sur le second côté (107, 207) de la fente (102, 202).

13. Procédé selon la revendication 10, dans lequel la formation de la fente (102, 202) comprend la formation de la fente (102, 202) à l'aide d'un laser et d'une gravure par voie humide.

14. Procédé selon la revendication 10, dans lequel le procédé comprend le dépôt d'une couche protectrice sur un certain nombre de surfaces des couches minces (230).
